Europäisches Patentamt

European Patent Office

Office européen des brevets

(11) Publication number: **0 340 870**
**A2**

## (12) EUROPEAN PATENT APPLICATION

(21) Application number: **89201120.6**

(22) Date of filing: **01.05.89**

(51) Int. Cl.⁴: **H03L 7/18 , H03C 3/09**

(30) Priority: **06.05.88 BE 8800516**
**13.09.88 BE 8801055**

(43) Date of publication of application:
**08.11.89 Bulletin 89/45**

(84) Designated Contracting States:
**AT BE DE ES FR GB GR IT LU NL SE**

(71) Applicant: **Alcatel N.V.**
**Strawinskylaan 537**
**NL-1077 XX Amsterdam(NL)**

(84) **DE ES FR GB GR IT LU NL SE AT**

Applicant: **BELL TELEPHONE**
**MANUFACTURING COMPANY Naamloze**
**Vennootschap**
**Francis Wellesplein 1**
**B-2018 Antwerp(BE)**

(84) **BE**

(72) Inventor: **Vanwelsenaers, Arnoul Octaaf**
**Gabriel**
**Prins Boudewijnlaan 392**
**B-2520 Edegem(BE)**

(74) Representative: **Vermeersch, Robert et al**
**BELL TELEPHONE MANUFACTURING**
**COMPANY Naamloze Vennootschap Patent**
**Department Francis Wellesplein 1**
**B-2018 Antwerp(BE)**

(54) **Digital frequency synthesizer and digital modulator using same.**

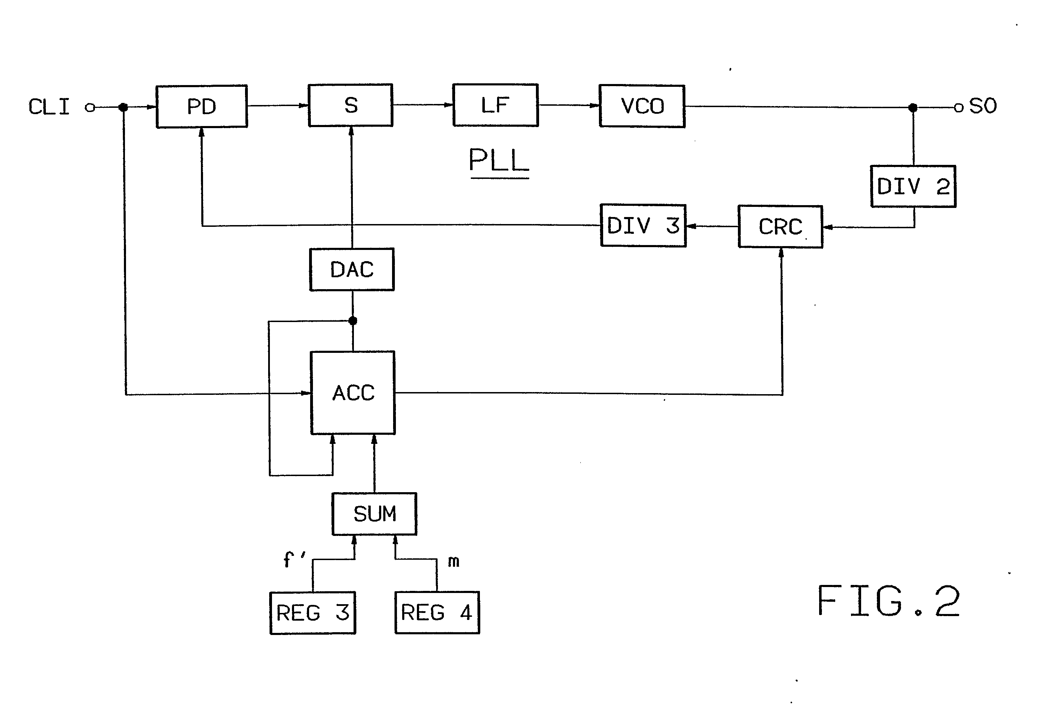

(57) The digital modulator shown in Fig. 2 provides at its output SO a signal whose frequency f1 is equal to the product of a clock frequency f2, applied to its input CLI, a second integer P by which a divider DIV2 divides, and a factor equal to the sum of another integer $N'$ by which a divider DIV3 divides, and a rational number $(F' + M)/P$. Because the latter is smaller than unity use can be made of a well known accumulator ACC and of a single-cycle removing circuit CRC. With f2 = 3.25 MHz, P = 16, $N' = 17$, the following modulated carrier frequencies may for instance be obtained :

$$890.2 + 3.25 \, M = 3.25 \times 16 \left[ 17 + \frac{992 + m}{520 \times 16} \right]$$

$$914.8 + 3.25 \, M = 3.25 \times 16 \left[ 17 \times \frac{4928 + m}{520 \times 16} \right]$$

wherein $M = \dfrac{M}{520}$ with m varying between 0 and 519 and

$$F' = \frac{992}{520} \text{ and } \frac{4928}{520} \text{ respectively.}$$

FIG.2

## DIGITAL FREQUENCY SYNTHESIZER AND DIGITAL MODULATOR USING SAME

The present invention relates to a digital frequency synthesizer providing an output signal whose output frequency f1 is a function of the clock frequency f2 of a clock signal and a digital frequency value of an input signal.

Such a digital frequency synthesizer is already known from the article "New Universal All-Digital CPM Modulator" by A. Kopta et al, published in IEEE Transactions on Communications, Vol. COM-35, No 4, April 1987, pp 458-462.

This known digital frequency synthesizer is a so-called number controlled oscillator which is controlled by the above mentioned digital frequency value and provides an output signal whose frequency is equal to the clock frequency multiplied by a factor which is smaller than half of unity.

Because the presently available number controlled oscillators operate at a clock frequency of e.g. 30 MHz the known synthesizer is not suitable for being used in a system operating at a much higher frequency, such as a cellular mobile radio system having a frequency range of e.g. 890.2 to 914.8 MHz.

If one would nevertheless like to use this known synthesizer to provide an output signal whose frequency is very much higher than the clock frequency by which it is controlled, it would be possible to mix in a frequency mixer the output signal of this synthesizer with a carrier wave having a higher frequency, thereafter removing by suitable filter means all unwanted frequency signals. If the output signal should have a selectable carrier frequency, such as in a cellular mobile radio system, it would be necessary to make use of a frequency synthesizer able to generate a range of such carrier waves. However, in this case the filter means would have to be different for each of the selected carrier frequencies and to be very selective since they have to filter out unwanted frequencies belonging to the range of frequencies generated by the frequency synthesizer.

This possible solution is therefore not acceptable.

An object of the present invention is to provide a digital synthesizer of the above type, but which is able to provide an output signal which has a selectable frequency equal to a fractional multiple of the clock frequency and does not require the use neither of a frequency mixer nor of filter means which are function of the selected frequency.

According to the invention this object is achieved due to the fact that said digital frequency synthesizer is of the type performing a fractional multiplication of said clock frequency f2, said output frequency f1 being equal to the product of said clock frequency and factor equal to the sum of an integer and a rational number itself equal to the sum of a first fractional part of unity and a second fractional part of unity which is said digital frequency value.

In this way the digital frequency synthesizer with fractional multiplication processes the second fractional part of unity or digital frequency value in the same way as the first fractional part of unity normally used to realise a fractional multiplication and therefore provides an output signal which is modulated by this digital frequency value. In other words, the invention is based on the insight that a digital frequency synthesizer with fractional multiplication may be used as a modulator by processing a modulating input signal in the same way as the first fractional part of unity by which the clock frequency is normally multiplied.

It should be noted that a digital frequency synthesizer with fractional multiplication is well known in the art, e.g. from the book "Frequency Synthesizers Theory and Design" by V. Manassewitsch, Second Edition, John Wiley and Sons and more particularly from pp 43-48 thereof, as well as from the book "Phase-Locked Loops Theory, Design and Applications " by R.F. Best, McGraw Hill, 1984 and more particularly from pp 222-229 thereof. However, none of these known frequency synthesizers is used as a modulator.

Another object of the present invention is to provide a digital frequency synthesizer or modulator allowing the use of relatively simple accumulator and cycle control circuits as well as uniform circuitry for a large number of different carrier frequencies, e.g. in a mobile radio communication system.

According to the invention this object is achieved due to the fact that said digital frequency synthesizer includes means to multiply said factor by a second integer and that the magnitude of said rational number is smaller than unity.

Because the above rational number is smaller than unity use may be made of a relatively simple known cycle removing circuit, able to remove only one cycle, and of a relatively simple known accumulator, e.g. according to US patent No. 3928813, providing an output signal to the cycle removing circuit only when such a cycle has to be removed. Also the multipication by the second integer can be carried out by simply introducing a divider circuit in a phase-locked loop, e.g. as shown in the book "Phaselock techniques" by F.M. Gardner, John Wiley and Sons, Inc., 1966 page 78, this without changing the clock frequency f2.

EP 0 340 870 A2

Indeed, otherwise f2 might have to be many times larger than a preferable value of e.g. 3.25 MHz and a change of technology necessary, possibly resulting in less reliable and/or more expensive designs. Moreover it is not always possible to change the clock frequency as it is function of other parameters. For instance, the clock frequency is equal to that at which the modulating signals are supplied to the accumulator and these signals are obtained by sampling a frequency path selected among 8 such paths by using a bit of an incoming bitstream and two previous bits of this bitstream. This means that the clock frequency is equal to 12 times the bitstream frequency. For instance, with a bit frequency of about 270 kHz the sample and clock frequencies both are equal to 3.25 MHz mentioned above.

The above mentioned and other objects and features of the invention will become more apparent and the invention itself will be best understood by referring to the following description of an embodiment taken in conjunction with the accompanying drawing wherein

Fig. 1 shows a first embodiment of a digital frequency modulator including a digital frequency synthesizer according to the invention;

Fig. 2 represents a second embodiment of such a modulator and synthesizer.

The digital frequency modulator f1 includes a digital frequency synthesizer with fractional multiplication of the same type as the one shown and described in the first mentioned book. Indeed, it has a clock input CLI and a signal output SO and includes a phase-locked loop PLL, an accumulator ACC, a digital-to-analog converter DAC and registers REG1 and REG2. The phase locked loop PLL comprises a forward path which includes the cascade connection between CLI and SO of a phase detector PD, an adder circuit S, a lowpass filter LF and a voltage controlled oscillator VCO. The feedback path of this loop includes the cascade connection between SO and the other input of the phase detector PD of a cycle removing circuit CRC and of a divider circuit DIV1 to which the output N of register REG1 is connected.

The accumulator ACC has a carry output connected to an input of the adder circuit S through the converter DAC as well as four inputs each, except the first, comprising in reality a set of parallel terminals : a first one connected to the clock input CLI, a second one connected to the accumulator carry output, a third one connected to the output F of the register REG2, and a fourth one SI to which a modulating input signal and having a positive or negative value is applied. The accumulator ACC also has a number of control outputs S1 to S3 which are connected to the cycle removing circuit CRC.

The above modulator is for instance adapted to be used in a cellular mobile radio system to frequency modulate a carrier wave having one of the 124 frequencies f1 from 890.2 to 914.8 MHz with a spacing of 200 kHz between adjacent frequencies.

This frequency range is used for transmission between the mobile unit and the base unit, whilst for the transmission in the reverse direction the frequency range is from 935.2 to 959.8 MHz. To this end Gaussian Minimum Shift Keying is used.

A clock signal having a clock frequency f2 is applied to the clock signal input CLI, whilst a modulating signal is applied to the signal input SI. This signal for instance has a frequency M.f2 equal to m/k units f2 or to m units or fractions f2/k. In other words

$$M = m/k \quad (1)$$

With f2 = 3.25 MHz and k = 520 the frequency M.f2 of the modulating signal is equal to m units of 6.25 kHz corresponding to 1/k th of 3.25 MHz and to 1/32 th of 200 kHz, with k = 520. The value m for instance varies between -31 and +31.

The modulating signal is for instance coded with 6 bits, one for the sign add the remaining five for the magnitude equal to m units of 6.25 kHz. This signal is e.g. obtained from an input bitstream, in a manner similar to the one described in the above mentioned article. This happens by using each set of the last three bits of this bitstream as an address for one of 8 possible frequency paths stored in a Read-Only-Memory (ROM) and by then reading 12 stored digital samples of the thus selected frequency path.

When expressing the above mentioned carrier frequency f1 as a fractional multiple of the clock frequency f2, i.e. as the product of f2 and a factor equal to the sum of an integer N and an adjustable fractional part of unity F, one may write the following relationship if f2.F is expressed in, say f, of the same units, equal to 6.25 kHz, as the above algebraic magnitude M :

$$f1 = f2 (N + F) \quad (2)$$

with $F = f/k \quad (3)$

and f varying between 0 and 519.

For instance, the carrier wave frequencies f1 = 890.8 MHz and f1 = 897 MHz may be written as follows :

$$890.8 \text{ MHz} = 3.25 (274 + \frac{48}{520}) \text{ MHz} \quad (4)$$

$$897 \text{ MHz} = 3.25 (276 + \frac{0}{520}) \text{ MHz} \quad (5)$$

4

As described in the first mentioned book, when an integer value N expressed in units of f2 and the fractional part of unity F expressed in f units of f2/k are applied to the inputs N and F of the frequency synthesizer respectively, the latter provides at its outputs SO a carrier wave having a frequency f1 whose mean value is given by the relation (2). Thereby the accumulator ACC operates the cycle removing circuit CRC via a control signal depending on the integer value of the accumulated arithmetic sum in such a way that it removes one cycle, each time this value is equal to one. The accumulator then also applies the carry value, i.e. the accumulated sum minus 1, to its first input.

The accumulator ACC used here differs from the known one in that it has an additional input SI which is fully equivalent to the input F but to which the algebraic fractional part of unity M is applied and in that it is able to accumulate the algebraic sum F + M and to generate distinct control signals S1/3 each for a different integer value of this sum.

Because the accumulator AC processes the term F + M in the same way as the value F in the known frequency synthesizer, the modulated output signal provided at the output SO of this synthesizer has a frequency whose mean value is given by the relation :

$$f = f2 (N + F + M) \qquad (6)$$

This means that the carrier frequency f1 = f2 (N + F) is modulated by the signal f2.M.

With the above given fractional values of F and M the integer value of the algebraic sum accumulated in the accumulator ACC is comprised between -1 and +2.

Indeed, when for instance :

- the previous accumulated value $A1 = \dfrac{519}{520}$ and

$$F + M = \frac{504}{520} + \frac{31}{520} = \frac{535}{520} \quad \text{then the new accumulated value}$$

$$A2 = A1 + F + M \quad \frac{1054}{520} = 2 + \frac{34}{520} \; ,$$

$$- \text{ when } A1 = \frac{0}{520} \text{ and } F + M = \frac{535}{520} \text{ then } A2 = 1 + \frac{15}{520} \; ;$$

$$- \text{ when } A1 = \frac{0}{520}$$

$$\text{and } F + M = - \frac{31}{520} \text{ then } A2 = - \frac{31}{520}$$

$$- \text{ when } A1 = \frac{-519}{520} \text{ and } F + M = \frac{-31}{520} \text{ then } A2 = \frac{-550}{520} = -1 - \frac{30}{520} \; ,$$

In order that the frequency synthesizer should operate correctly it should realize a division by N-1, N, N + 1 and N + 2 when the integer value of the accumulated algebraic sum is equal to -1, 0, 1 and 2 respectively. The accumulator ACC could control the circuit CRC in such a way that the latter :
- removes 0, 1 or 2 cycles of the output signal of the VCO when the integer value is equal to 0, 1 and 2 respectively;
- adds 1 cycle when this integer value is equal to -1.

But such a circuit CRC should then be able not only to remove one (N + 1) or two (N + 2) cycles but also to add one cycle (N-1). Since this is not possible the divider circuit DIV1 is controlled by the value, N-1, instead of N, stored in the register REG1. Then, to realise the above mentioned division by N-1, N, N + 1 or N + 2 a corresponding number of 0, 1, 2 or 3 cycles or pulses have to be removed. To this end the control signals S1, S2 and S3 generated by ACC to indicate that the integer value of the accumulated algebraic sum is equal to 0, 1 or 2 are used to control the cycle removing circuit CRC in such a way that the latter removes a corresponding number of 1, 2 or 3 cycles or pulses.

In general, when the integer value of the sum accumulated in ACC can take one of the values -q to n then the divider DIV1 realises a division by N-q and the accumulator ACC provides control signals indicating that 1 to q + n cycles have to be removed from the VCO output signal.

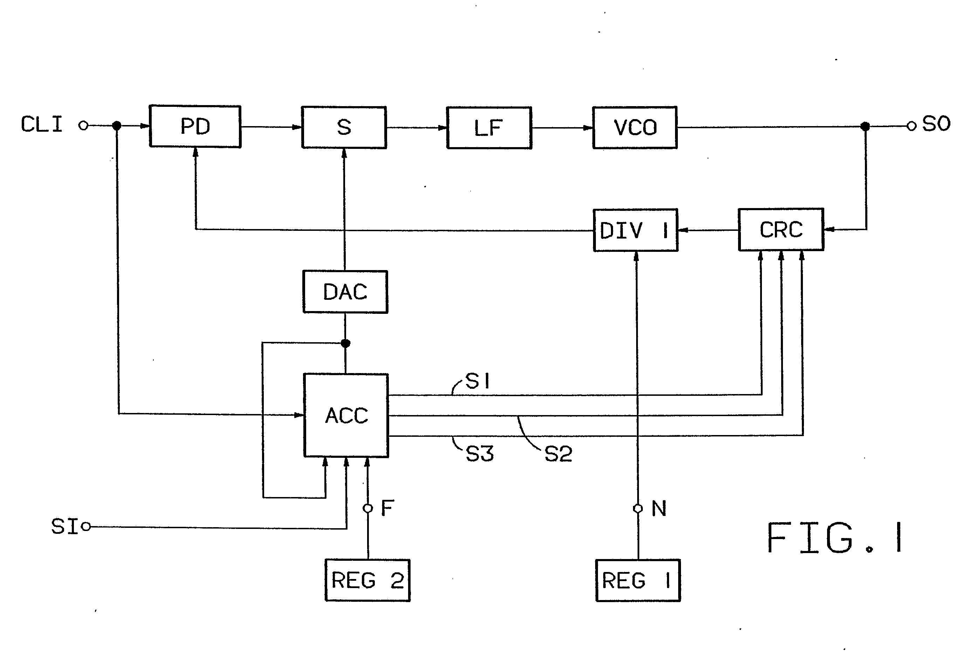

Reference is now made to Fig. 2 which makes use of an accumulator ACC and a cycle control circuit CRC which are less complex than those of Fig. 1.

The digital modulator shown is based on the insight that a particular linear transformation of the above relation (6), i.e.

$$f1 = Pf2 [N' + (F' + M)/P] \qquad (7)$$

can lead to simplified circuits. In (7), the parameters N and F of (6) have been linearly transformed into N' and F' respectively by using the relations

$$N = PN' + R \qquad (8)$$

$$F + R = F' \qquad (9)$$

in which N' is the positive integral part of N/P making R/P a fraction smaller than unity, with the new parameter P and the new parameter R, which does not appear in (7), being positive integers.

To be noted from (8) that P and N' are interchangeable as long as each is larger than R so that in such a case (7) can also be written

$$f1 = N'f2 [P + (F' + M)/N'] \qquad (10)$$

Also, (1) can be written

$$f1 = Pf2 [N' + 1 - (P - F' - M)/P] \qquad (11)$$

showing this time a negative fraction and corresponding to the possiblity of a cycle adding circuit mentioned in the above US patent.

Thus, by multiplying f2 by P so that it becomes Pf2 one can keep a similar relation between f1 and f2 since N' is still an integer like N while both F'/P and M/P are still fractional parts of unity like F and M respectively, but with the possibility that this can now also be true for their sum.

Moreover, when considering a predetermined range of frequencies f1 extending from a minimum of f11 to a maximum of f12 it now becomes possible also to keep the same integer value of N' in (7) for all frequencies in the range while (F' + M)/P remains smaller than unity and this contrary to N and F + M appearing in (6). This is satisfied provided

$$f12 - Pf2 < N'Pf2 <= f11 \qquad (12)$$

$$f12 - f11 < Pf2 \qquad (13)$$

In this manner, the particular accumulator used in the modulator of Fig. 1 to control the cycle swallowing process, enabling divisions by numbers having a fractional component and providing four possible outputs after each clock period need no longer be used. Instead of such an accumulator indicating that one or two cycles should be removed or none, or that one cycle should be added, it becomes possible to rely on the simple previous practice of only one cycle removal or none.

Using relation (6) and with the relations (1) and (3) and assuming positive or negative values between -31 and +31 the carrier wave frequencies such as 890.2 and 914.8 MHz, the lowest and highest in the range, can be expressed as

$$890.2 + 3.25 \; M = 3.25 \; (273 + \frac{472 + m}{520}) \qquad (14)$$

$$914.8 + 3.25 \; M = 3.25 \; (281 + \frac{248 + m}{520}) \qquad (15)$$

With the overall frequency range for such modulated carrier waves extending between f11 equal to 890 MHz and f12 equal to 915 MHz, and restricting the choice of P to powers of two so as to facilitate implementation, the smallest such value of P satisfying (13) is 8. However, this implies that (12) becomes

$$915 - 26 = 889 < 26 \; N' <= 890 \qquad (16)$$

which cannot be satisfied for an integer value of N', whereas with P equal to 16 one has

$$915 - 52 = 863 < 52 \; N' <= 890 \qquad (17)$$

range which allows N' to be equal to 17 with the alternative of P = 17 and N' = 16 as per relation (10).

The normalized modulated carrier frequencies (14) and (15) can now be rewritten using relation (7) with $M = \frac{m}{k}$, $F' = \frac{f'}{k}$ and k = 520 i.e.

$$890.2 + 3.25 \ M = 16 \times 3.25 \ (17 + \frac{992 + m}{520 \times 16})$$

$$= 17 \times 3.25 \ (16 + \frac{992 + m}{520 \times 17}) \qquad (18)$$

$$914.8 + 3.25 \ M = 16 \times 3.25 \ (17 + \frac{4928 + m}{520 \times 16})$$

$$= 17 \times 3.25 \ (16 + \frac{4928 + m}{520 \times 17}) \qquad (19)$$

since (8) and (9) lead to R equal to 1 and $F'$ equal to $f'/k = 992/520$ for (18) and to 9 and 4928/520 for (19).

Thus, for the above range limiting frequencies, as well as for all 124 carrier frequencies of the range considered, $N'$ is now constant, i.e. always equal to 17, instead, of N being a variable integer, e.g. (14) and (15) or with P = 8, while the fractional part $(F' + M)/P$ can never exceed unity. A constant $N'$ equal to 15 or 18, with P equal to the other value, is also possible but these values are not powers of two.

To be noted that while the above minimum power of two solution for P leads to an integer value of the same order for $N'$ both being much lower than the values of N in relations (14) and (15) since these are of the order of $PN'$ larger powers of two for P, and also satisfying relations (12) and (13), lead to $N'$ being also a (lower) power of two including unity, i.e. $PN' = 256$ with P = 32 and $N' = 8$, or P = 64 and $N' = 4$, or P = 128 and $N' = 2$, or P = 256 and $N' = 1$. This offers the advantage that whereas P = 16 and $N' = 17$, or vice-versa, eases the implementation either for P or for $N'$ both can now use dividers which are powers of two.

With $PN' = 256$, R is now 17 for relation (14) and 25 for relation (15) so that exchanging P and $N'$ is not possible and P = 32, 64, 128 or 256 are the only solutions but with $N'$ (8, 4, 2 or 1 respectively) remaining constant for the whole range of 124 carrier frequencies considered. These four solutions give

$$890.2 + 3.25 \ M = P \times 3.25 \ [\ \frac{256}{P} + \frac{9312 + m}{520 \times P}\ ] \qquad (20)$$

$$914.8 + 3.25 \ M = P \times 3.25 \ [\ \frac{256}{P} + \frac{13248 + m}{520 \times P}\ ] \qquad (21)$$

with P = 32, 64, 128 or 256, this last value offering the added advantage of $N'$ being equal to unity.

The digital modulator shown in Fig. 2 includes a digital frequency synthesizer with a phase-locked loop PLL, an accumulator ACC, a digital-to-analog converter DAC, a summing circuit SUM and registers REG1 and REG2. The phase-locked loop PLL has a clock input CLI and a signal output SO and comprises a forward path which includes the cascade connection between CLI and SO of a phase detector PD, an adder circuit S, a lowpass filter LF and a voltage controlled oscillator VCO. The feedback path of this loop includes the cascade connection between SO and the other input of the phase detector PD of a divider circuit DIV2 which provides a division by the integer P, a single cycle removing circuit CRC, and a divider circuit DIV3 which provides a division by the integer $N'$.

The accumulator ACC has a first input connected to the clock input CLI, a second input connected to the accumulator carry overflow output and a third input connected to the output of the summing circuit SUM. It has a cycle removing output connected to the single cycle removing circuit CRC and its carry output is connected to the adder circuit S through the converter DAC.

The summing circuit SUM has first and second inputs connected to the outputs $f'$ and m of the registers REG3 and REG4 respectively.

The registers REG3 and REG4 store the values $f'$ and m respectively in frequency units of 6.25 kHz. Because m is variable between -31 and 31 the register REG2 is a 6-bit register with 1 bit for the sign and 5 bits for the magnitude. The register REG3 is for instance a Read-Only-Memory storing the 124 13-bit values of $f'$ corresponding to the 124 modulated carrier frequencies varying between 890.2 and 914.8 MHz and spaced apart by 200 kHz as considered above. This means that for P = 16 the 124 values of $f'$ vary between 992 and 4928, e.g. relations (20) and (21), and may be selected by means of a 7-bit selection code.

The above described modulator operates as follows.

When the clock frequency f2 = 3.25 MHz is applied to the input CLI a signal with output frequency f1 is generated at the output SO. Because the divider DIV2 provides for a division by P the frequency at the input of the cycle removing circuit CRC is equal to f1/P. The summing circuit SUM adds the above values f' and m and applies the resultant 13-bit sum value to ACC which is an accumulator mod (520 x 16) operated each time the clock signal CLI is activated. When the sum thus accumulated in ACC overshoots a value equal to 520 x 16 the accumulator ACC generates a cycle removing signal which is applied to the circuit CRC, while 520 x 16 is subtracted from the accumulated sum due to the carry overflow feedback connection. Circuit CRC then removes one cycle from the input signal with frequency f1/P since from such relations as (20) and (21) it is clear that each unit of N' corresponds to 16x3.25 MHz or to 16x520x6.25 kHz, i.e. to 16x520 units of 6.25 kHz.

Thus, with P and N' both constant for the whole frequency range the same divider circuits DIV1 and DIV2 can be used for each of the 124 frequencies of this range. Also, because (F' + M)/P is smaller than 1 the accumulator ACC has only to provide an active single cycle swallowing output signal to CRC when the predetermined value 520x16 is reached. Indeed, after each overflow the accumulator containing a value less than 520 x 16 and receiving (F' + M)/P also less than this value can only produce an overflow or not for the next clock pulse.

While the principles of the invention have been described above in connection with specific apparatus, it is to be clearly understood that this description is made only by way of example and not as a limitation on the scope of the invention.


## Claims

1. Digital frequency synthesizer providing an output signal whose output frequency f1 is a function of the clock frequency f2 of a clock signal (CL1) and of a digital frequency value of an input signal, characterized in that it is of the type performing a fractional multiplication of said clock frequency f2, said output frequency f1 being equal to the product of said clock frequency f2 and a factor equal to the sum (N + F + M; N' + (F' + M)/P) of an integer value (N; N') and a rational number (F + M; (F' + M)/P) itself equal to the sum of a first fractional part of unity (F; F') and a second fractional part of unity (M; M/P) which is said digital frequency value.

2. Digital frequency synthesizer according to claim 1, characterized in that it includes further means to multiply said factor by a second integer (P) and that the magnitude of said rational number [(F' + M)/P] is smaller than unity.

3. Digital frequency synthesizer according to claim 2, c.i.t. for a predetermined range of said output frequency f1 extending from a minimum f11 to a maximum f12

f12 - Pf2 < N' Pf2 < = f11

and

f12 - f11 < Pf2

wherein N' and P are said first and second integers respectively.

4. Digital frequency synthesizer according to claim 3, c.i.t. said first integer (N') is constant for all output frequencies of said range.

5. Digital frequency synthesizer according to claim 2, c.i.t. said first integer (N') is a power of 2.

6. Digital frequency synthesizer according to claim 2, c.i.t. said first integer (N') is equal to 1.

7. Digital frequency synthesizer according to claim 2, c.i.t. said second integer (P) is a power of 2.

8. Digital frequency synthesizer according to claim 2, characterized in that it includes an accumulator means (ACC, REG3/4) which is controlled by said clock signal (CLI), calculates an accumulated value which is function of said rational number (F' + M)/P and provides an activated control signal each time the integer part of said accumulated value reaches a predetermined value, as well as a phase-locked loop whose forward path is controlled by said clock signal (CLI) and includes the cascade connection of at least a phase detector (PD) and a controlled oscillator (VCO) providing said output signal (SO) and the feedback path (DIV2, CRC, DIV3) of which includes the cascade connection of at least a first divider circuit (DIV2) dividing by said second integer (P), a single cycle control circuit (CRC) controlled by the output signal of said accumulator means and a second divider circuit (DIV2) dividing by said first integer (N').

9. Digital frequency synthesizer according to claim 1, characterized in that it includes an accumulator (ACC) which is controlled by said clock signal (CLI), calculates the accumulated algebraic value of said rational number (F + M) and provides at least one first control signal (S1/3) which is function of the integer

8

part (0, 1, 2) of said accumulated value, as well as a phase-locked loop whose forward path (PD, S, LF, VCO) is controlled by said clock signal (CLI) and includes the cascade connection of at least a phase detector (PD) and a controlled oscillator (VCO) providing said output signal (SO) and the feedback path (CRC, DIV1) of which includes the cascade connection of at least a cycle removing circuit (CRC) able to remove cycles from said output signal and a divider circuit (DIV1), said cycle removing circuit (CRC) being controlled by said first control signal (S1/3) and said divider circuit (DIV1) being controlled by a second control signal which is a function (N-1) of said integer value (N), that said first fractional part (F) and the absolute value of said second fractional part (M) are each larger than or equal to zero and smaller than 1, and that said accumulator (ACC) has first (F) and second (SI) inputs for said first (F) and second (M) fractional parts and is provided with a number of outputs (S1/3) which are activated for distinct values (0, 1, 2) of said integer part of said accumulated algebraic value.

10. Digital modulator characterized by a digital frequency synthesizer according to any of the claims 1 to 9.

11. Digital modulator according to any of the claims 1 to 8 and to claim 10, characterized in that MF2 is a modulating input signal, that $f' = kF'$ and $M = kM$ with $f'$ and k being positive integers, m a positive or negative integer and with k larger than $f'$ and larger than m, and that the values of $f'$ and m are added in a summing circuit (SUM) before being applied to said accumulator (ACC) for which said predetermined value is equal to kP.

FIG. I

EP 0 340 870 A2

FIG.2